# EUROPEAN PATENT SPECIFICATION

(11) **EP 2 225 773 B1**
(45) Date of publication and mention of the grant of the patent: **03.08.2011**
(21) Application number: 08869018.5
(22) Date of filing: 18.12.2008
(51) Int. Cl.: H01L 21/8242, H01L 27/07, H01L 21/02, H01L 27/108, H01L 27/02

(54) **Memory cell comprising a capacitor arranged laterally from a transistor**
Speicherzelle mit einem seitlich von einem Transistor angeordneten Kondensator
Cellule de mémoire ayant un condensateur positionné à côté d'un transistor

(30) Priority: 21.12.2007 EP 07291585
(43) Date of publication of application: 08.09.2010
(73) Proprietor: NXP B.V., 5656 AG Eindhoven (NL)
(72) Inventor: PUGET, Sophie, NL-5656 AG Eindhoven (NL); MAZOYER, Pascale, L., A., NL-5656 AG Eindhoven (NL)
(74) Representative: Krott, Michel
(86) International application number: PCT/IB2008/055414
(87) International publication number: WO 2009/083882

(56) References cited:
- FR-A- 2 849 962
- US-A1- 2007 205 449

## Description

### FIELD OF THE INVENTION

The present invention relates to a memory cell and to a memory device.

### BACKGROUND OF THE INVENTION

W. Mueller et. al., in "Challenges for the DRAM Cell Scaling to 40 nm", IEDM Tech. Dig., 2005, pp. 336 - 339, give a review on concepts for scaling DRAM memory cells down to 40 nm. Technology issues discussed for the DRAM capacitor concern trench capacitors on one hand and stack capacitors on the other hand. The scaling of a trench capacitor at constant cell capacitance is described as requiring an increase of the aspect ratio to a value of up to 120 and/or the use of alternative high-k dielectric materials. Similar requirements are reported to hold for stack capacitor structures.

A disadvantage of employing trench capacitors with high aspect ratios in sub-100 nm technologies is a lower manufacturing yield. A further disadvantage is an increase of manufacturing costs. Furthermore, the use of novel high-k materials for dielectric layers is problematic with respect to the process temperatures used in a typical CMOS process. Furthermore, the scaling of trench and stack capacitors bears an increased risk of junction leakage, which may show a negative impact on the memory effect.

A further technological issue of scaling DRAM memory cells relates to the cell transistor. When scaling the cell transistor gate length below 100 nm, the doping level required to meet the off-current criterion of I_{off} < 1 fA gets so high that the electric field at the node junction may exceed 0.5 MV/cm, thus initiating trap-assisted tunneling leakage.

It would be desirable to provide a memory cell structure and a memory device that allow a high manufacturing yield at low cost and that mitigate or completely remove the mentioned problems of a scaled memory cell suitable for DRAM.

US 20070205449 and FR 2849962 disclose memory devices comprising a capacitor integrated with a transistor.

### SUMMARY OF THE INVENTION

The invention is defined by the memory all of claim 1. According to a first aspect of the present invention, a memory cell is provided, comprising:
- a semiconductor substrate with an active semiconductor region, which is laterally defined on a surface of the semiconductor substrate by isolation regions adjacent to the active semiconductor region,
- a control transistor having semiconductor transistor-electrode regions within lateral bounds of the active semiconductor region and the isolation regions, and
- a memory capacitor on the active semiconductor region, the memory capacitor having a first capacitor-electrode layer, which, in a cross-sectional view of the memory cell, has first and second electrode-layer sections that extend on the active semiconductor region in parallel to the surface of the active semiconductor region at a vertical distance to each other and that are electrically connected by a third electrode-layer section extending vertically, that is, perpendicular to the surface of the active semiconductor region,
- wherein the control transistor is connected with a conductive second capacitor electrode layer that extends between the first and second electrode-layer sections and is electrically isolated from them by an isolation layer.

The memory cell of the first aspect of the present invention overcomes the mentioned disadvantages of the prior-art memory cell structures. Since no fabrication of deep trenches is required for the memory capacitor, a high manufacturing yield can be achieved.

The memory cell can further be fabricated without addition of a critical mask level in comparison to known processes. This keeps the manufacturing cost low. The risk of junction leakage is reduced by a small area of the junction. Furthermore, standard back-end interconnect processing is enabled in comparison with known memory cells comprising stack capacitors. The close contact between the structural elements of memory cell and the semiconductor substrate enables an efficient temperature dissipation under operation and in the manufacturing process, which reduces the relevance of the earlier mentioned temperature issues associated with the described prior-art technologies.

The memory cell of the first aspect of the present invention therefore is particularly suitable for memory devices with highly scaled structural elements, such as embedded DRAM (eDRAM), as used for instance in CMOS technology nodes employing transistor-gate lengths below 100 nm, and even at 65 nm and below.

The memory cell of the invention has the further advantage that trap-assisted tunneling leakage can be reduced. The junction leakage is linked to junction area. As the capacitor surrounds the drain junction, the leakage path is drastically reduced.

In the following, embodiments of the memory cell of the invention will be described. Unless stated otherwise or obvious from the description, the described embodiments can be combined with each other to form further embodiments.

The specific shape of the memory capacitor on the active semiconductor region is characterized by its "planar" (as opposed to trench or stacked architectures) three-dimensional memory capacitor with a particular shape of the first capacitor-electrode layer, as described above with reference to the first, second and third electrode-layer sections of this first capacitor-electrode layer.

Within the framework of the above definition, several embodiments of the structure of the first electrode-layer are possible. In one embodiment, the first electrode-layer has a shape, which in the mentioned cross-sectional view resembles the upper-case letter U turned on its side. That means, the first and second electrode-layer section of the first capacitor-electrode layer form longitudinal bars of the letter U, which correspond to the vertical bars of the upright letter U. The third electrode-layer section forms the "connecting piece" between them, which in an upright letter U forms the horizontal bar. That is, in this embodiment the letter U rests on one of its longitudinal bars. The two longitudinal bars of the first capacitor-electrode layer extend in parallel to the surface of the active semiconductor region, along their longitudinal direction in the mentioned cross-sectional view.

The longitudinal U-bars need not have the same length, or, in other words, longitudinal extension in the cross-sectional view under consideration. The longitudinal extension of the first and second electrode-layer sections can differ to the point where the shape of the first electrode layer resembles the upper-case letter J turned on its side. For the purpose of definition, an embodiment can be considered to have a J-shape, if the ratio of the longitudinal extensions of the longer to the shorter electrode-layer section of the first and second electrode-layer sections is larger than 2, but normally smaller than 100. Suitably, for the J-shape, the ratio is smaller than 10, preferably even smaller than 5. If the ratio is smaller than 2, the memory capacitor is considered to have a U-shape for the purpose of the present definition. A perfect U-shape is present if the value of the ratio equals 1.

The J-shape is considered to be different from an L-shape, for which the mentioned ratio would be mathematically infinite. For the purpose of clarification, the memory-capacitor embodiment with the shape of the letter J turned on its side has first and second electrode-layer sections parallel to each other, one of them corresponding to the long vertical bar of the upright upper-case letter J, and the other one corresponding to the short bar of the upright upper-case letter J. Both are connected through the third electrode-layer section. In contrast, the upright upper-case letter L has no short second electrode-layer section parallel to a long first electrode-layer section, i.e., to the vertical L bar, but only a horizontal (third) electrode-layer section. The J-shape and the U-shape of the memory-capacitor in the present invention allows the previously mentioned reduction of the junction area. This is not the case for the L shape.

With the memory capacitor according to the memory cell of the first aspect of the present invention, an optimization of the capacitance value of the memory capacitor in relation to its geometrical intension is achieved in comparison with an L-shaped memory capacitor. Of course, the present comparison with the shapes of upper-case letters serves primarily to support the intuitive understanding of the geometrical structure of the embodiments. No typographical details like the presence or absence of serifs of printed letters are taken into consideration for the purpose of the present discussion of the geometrical shape of the memory capacitor in the cross-sectional view.

Given otherwise identical geometrical parameters, an embodiment with a U-shape will have a larger capacitance than one with a J-shape. The capacitance value is defined by the common surface between the first and second capacitor electrode layer. Since the first capacitor-electrode layer is segmented into three electrode-layer sections, it is the common surface shared by the second capacitor-electrode layer and the three electrode-layer sections that is to be considered. The larger longitudinal extension of the shorter electrode-layer section in comparison with the longer electrode-layer section in the J-shape, the higher is the capacitance of the memory capacitor, provided no other geometrical parameters of the capacitor structure are changed.

However, aspects of technological feasibility may additionally influence the selection of a particular capacitor shape for a particular memory-cell structure.

Suitably, to make fabrication easier, the electrode-layer section with the shorter longitudinal extension is that with a larger vertical distance to the surface of the active semiconductor region. Note, however, that in some embodiments, the electrode-layer section with a larger vertical distance from the surface of the active semiconductor region has, in the cross-sectional view, a longer longitudinal extension than the electrode-layer section that is closer to the surface of the active semiconductor region.

The memory cell has a semiconductor intermediate layer, which is arranged on the surface region in the active semiconductor region.

Furthermore, a semiconductor electrode layer is arranged on the intermediate layer and comprises at least one of the transistor-electrode regions. Furthermore, the semiconductor electrode layer continues laterally into the second capacitor electrode layer. In one embodiment, the semiconductor electrode layer and the second capacitor layer form adjacent regions of the same semiconductor layer. An advantage of the present embodiment is that it is particularly easy to implement into existing CMOS and BiCMOS technologies.

In the structure of this embodiment, the semiconductor intermediate layer is preferably made of a semiconductor material, which is selectively removable with respect to the semiconductor substrate. A suitable choice of materials is for instance silicon for the substrate material and the second capacitor electrode layer, and silicon-germanium SiGe for the semiconductor intermediate layer.

The control transistor is typically a MOSFET having source and drain regions arranged as transistor-electrode regions in the semiconductor electrode layer. In this embodiment, which is based on the structure of the previous embodiment using the intermediate layer on the surface region in the active semiconductor region, the drain region continues laterally into the second capacitor-electrode layer. This means, the semiconductor electrode layer contains the source and drain regions of the control transistor as well as the second capacitor-electrode layer in different sections. This embodiment is particularly compact.

The control MOSFET of this memory-cell embodiment preferably has a gate-electrode layer, which is made of an electrically conductive material which may be the same as the material of the first capacitor-electrode layer. For this embodiment, the first capacitor-electrode layer and the gate-electrode layer can be deposited in the same deposition step.

Later on, they can be separated by patterning, as will be described in the context of preferred embodiments of the method of the third aspect of the invention with respect to the Figures.

However, in an alternative embodiment, the MOSFET has a gate-electrode layer, which is made of an electrically conductive material, which is different from that first capacitor-electrode layer. This embodiment requires an additional mask for the separate definition of the gate-electrode layer and the first capacitor-electrode layer. It has the advantage, that the materials compositions of theses layers can be tailored independently according to the needs of a particular application. A second aspect of the present invention is formed by a memory device comprising a plurality of memory cells according to the first aspect of the invention or one of its embodiments.

The memory device of the second aspect of the invention shares the advantages of the memory cell of the first aspect of the invention. It can be produced with a high manufacturing yield, at low cost, with particularly favorable temperature-dissipation properties in a bulk substrate.

In the following, embodiments of the memory device of the second aspect of the invention will be described. As before, embodiments of the memory device can be combined with each other, to form additional embodiments, unless stated otherwise or obvious from the description as forming alternatives.

In typical embodiments, the memory cells are provided in a matrix arrangement, each memory cell being connected to a respective unique combination of word and bit lines via two of its transistor-electrode regions. For instance, the respective word line is connected with the gate electrode of the control transistor of the memory cell, and the respective bit line is connected with the source electrode of the same control transistor of the same memory cell.

The advantage of the memory cell of the first aspect of the invention is reflected by several alternative memory architectures forming embodiments of the memory device of the second aspect of the invention.

In one architecture, adjacent memory cells of the matrix arrangement are provided in a back-to-front arrangement in a direction parallel to the bit lines. For the purpose of definition, the third electrode-layer section is to be considered the back side and the control transistor is considered as forming the front side of a memory cell.

In an alternative architecture, adjacent memory cells of the matrix arrangement are in a back-to-back arrangement in a direction parallel to the bit lines. Here, the same definitions of back and front applies.

The memory cells in back-to-back architectures can either be immediately connected through respective first capacitor-electrode layers, or separated from each other by a lateral distance, which can be filled with an isolating material. In this embodiment, the regions facing each other back-to-back are suitably arranged on the isolation regions that define adjacent active semiconductor regions, i.e., the shallow trench isolations.

According to an aspect not forming part of the invention, a method for fabricating a memory cell is provided. The method comprises the steps
- providing a semiconductor substrate with an active semiconductor region, which is laterally defined on a flat surface region of the semiconductor substrate by isolation regions adjacent to the active semiconductor region,
- fabricating a memory capacitor on the active semiconductor region with a first capacitor-electrode layer, which, in a cross-sectional view of the memory cell, has first and second electrode-layer sections that extend on the active semiconductor region in parallel to the surface of the active semiconductor region at a vertical distance to each other and that are electrically connected by a third electrode-layer section extending vertically, that is, perpendicular to the surface of the active semiconductor region, and with a second capacitor electrode layer that extends between the first and second electrode-layer sections and is electrically isolated from them by an isolation layer;
- fabricating a control transistor having semiconductor transistor-electrode regions within lateral bounds of the active semiconductor region and the isolation regions,
- wherein fabricating the control transistor comprises providing a connection of the control transistor with the second capacitor electrode layer.

The expression "within lateral bounds of the active semiconductor region and the isolation regions" refers to a lateral region that is limited by lateral side faces of the isolation regions facing away from the active semiconductor region.

In one example not forming part of the invention fabricating the memory capacitor comprises:
- depositing a layer stack of a first semiconductor layer on the surface of the active region and a second semiconductor layer on the first semiconductor layer, the material of the first semiconductor layer being chosen such that it is selectively removable without removing the second semiconductor layer and the material of the active semiconductor region;
- selectively removing a section of the first semiconductor layer, the section corresponding to the extension of one of the first and second electrode-layer sections of the first electrode layer, thus forming a tunnel section between the surface of the active semiconductor region and the side of the second semiconductor layer facing the surface of the active semiconductor region;
- depositing an isolation layer on the surface of the active semiconductor region and on the exposed surface of the second semiconductor layer;
- depositing a gate layer on the oxide layer, thereby also filling the tunnel section;
- patterning the gate layer on top of the second semiconductor layer to separate a transistor gate from on the other one of the first and second electrode-layer sections of the first electrode layer, wherein the patterning includes protecting the third electrode-layer section from removal.

Preferred embodiments of the invention are also defined in the dependent claims.

### BRIEF DESCRIPTION OF THE DRAWINGS

The foregoing and other aspects of the invention will be apparent from and elucidated with reference to the embodiment(s) described hereinafter. In the following drawings
Fig. 1 shows a schematic cross-sectional view of a memory cell according to a first embodiment of the invention.
Figs. 2 to 7 show schematic cross-sectional views of a memory cell according to a second embodiment at different stages of its fabrication, for illustrating a process flow according to a fabrication method not forming part of the invention.
Figs. 8 and 9 show schematic top and cross-sectional views of a memory cell according to a third embodiment of the invention. [It is always the same structure fig 8 corresponds to a top view of the first architecture]
Fig. 10 shows a memory device with a back-to-front architecture.
Figs. 11 to 13 show top and sectional views of a memory device with a first back-to-back architecture.
Figs. 14 to 16 show top and sectional views of a memory device with a second back-to-back architecture
Fig. 17 is a top view of a memory device for illustrating the cell area required by a memory cell. [in case of the second back to back architecture]

### DETAILED DESCRIPTION OF EMBODIMENTS

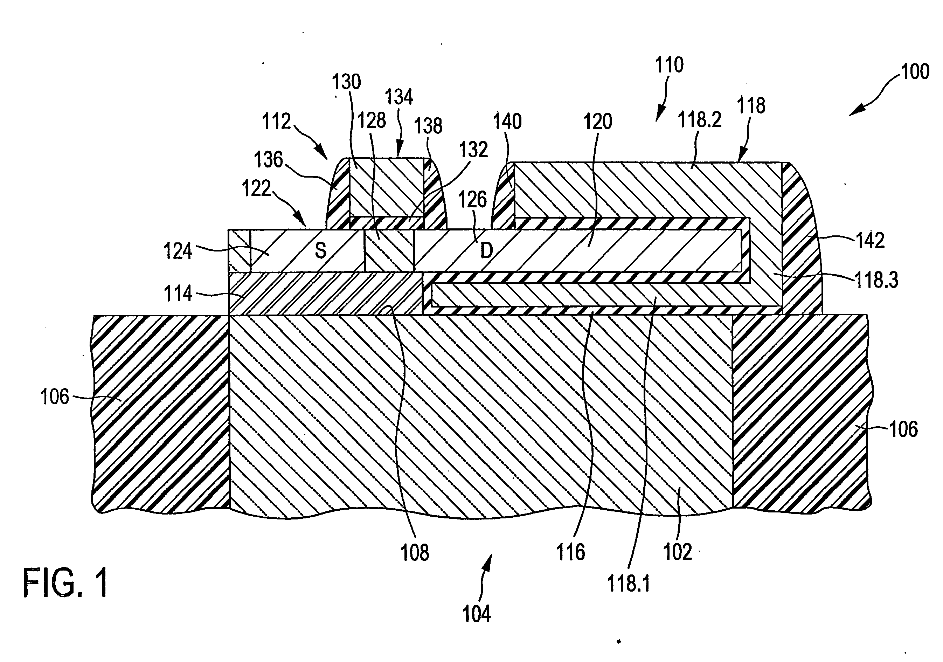

Fig. 1 shows a schematic cross-sectional view of a memory cell 100 according to a first embodiment of the invention. The memory cell 100 is provided on a silicon substrate 102. On the silicon substrate active semiconductor regions 104 are laterally defined by shallow trench isolation (STI) regions 106, as is well known from CMOS technology. Fig. 1 only shows a section of the substrate 102. The section comprises one active semiconductor region, which has a substantially flat surface 108. The substrate 102 is only shown to a depth that does not exceed the depth of the shallow trench isolation. Note that the graphical representation of the memory cell in Fig. 1 is purely schematic and not meant to reflect geometrical proportions adequately.

On the active semiconductor region 104, the active components of the memory cell 100 are provided. That is, a memory capacitor 110 and a control MOSFET 112 are arranged on the active semiconductor region. Note that the surface of the active semiconductor region 104 and of the shallow trench isolation regions 106 are flat, implying that the memory cell is built on the substrate 102 without a need to pattern the substrate surface other than by providing the STI regions 106.

The memory capacitor 110 extends on the active semiconductor region and on a part of the shallow-trench isolation region 106. However, the memory capacitor 110 does not extend over the whole lateral extension of the active semiconductor region 104. In the present embodiment slightly less than half of active semiconductor region, as seen in the cross-sectional of Fig. 1, is covered by a semiconductor intermediate layer 114. The semiconductor intermediate layer 114 is made of silicon germanium SiGe in the present embodiment. The memory capacitor 110 is separated from the silicon substrate 102 by an isolation layer 116.

The shape of the memory capacitor 110, as seen in the cross-sectional view of Fig. 1, resembles that of the letter U turned on its side. More specifically, the memory capacitor 110 has a first capacitor-electrode layer 118, which, in the cross-sectional view of Fig. 1, has a first electrode-layer section 118.1 next to the surface 108 of the active semiconductor region 104. A second electrode-layer section 118.2 is arranged in parallel to the first electrode-layer section 118.1 at a vertical distance. The first and second electrode-layer sections 118.1 and 118.2 correspond to the longitudinal bars of the letter U. Note that the first electrode-layer section 118.1 has a larger longitudinal extension than the second electrode-layer section. The first and second electrode-layer section 118.1 and 118.2 of the first capacitor-electrode layer 118 are connected by a vertical third electrode-layer section 118.3, which corresponds to the bottom section of a upright capital letter U.

The vertical distance between the first and second electrode-layer sections 118.1 and 118.2 is filled with a second capacitor-electrode layer 120 and an insulating layer that electrically isolates the first and second capacitor electrode layers from each other. That is, the second capacitor-electrode layer fills the space between the longitudinal bars of the letter U formed by the first capacitor-electrode layer 118. Regarding materials of the first and second capacitor electrode layers 118 and 120, the first capacitor-electrode layer 118 can be form of a metal or a suitably doped semiconductor material. The second capacitor-electrode layer 120 is formed of doped semiconductor material.

As is visible from Fig. 1, the second capacitor electrode layer 120 forms an integral part of a semiconductor electrode layer 122, which comprises source and drain regions 124 and 126 of the control transistor 112. The source and drain regions 124 and 126 are separated by a channel region 128 of the semiconductor electrode layer 122. The semiconductor electrode layer 122 is arranged on the semiconductor intermediate layer 114 and on the stack formed by the isolation layer 116 and the first electrode-layer section 118.1 of the first capacitor-electrode layer. Accordingly, the thickness of the semiconductor intermediate layer 114 and of this mentioned layer stack is equal.

The semiconductor electrode layer 122 is in the present embodiment made of silicon, which is suitably doped in the source and drain regions 124 and 126 and in the second capacitor-electrode layer 120. The conductivity type of the doped regions 124, 126 and 120 is identical. In the present embodiment, the conductivity type is n-conductivity.

On top of the semiconductor electrode layer 122, a gate stack 130 is provided.

The gate stack comprises a gate insulation layer 132 and a gate electrode layer 134. In the present embodiment, the gate electrode layer is made of the same material as the first capacitor-electrode layer 118. However, the materials are different in other embodiments, which allow tailoring the gate electrode and the capacitor according to specific application requirements. This individual tailoring of the gate and capacitor-electrode materials, however, requires some additional processing involving an additional mask. Insulating lateral spacers 136 and 138 are arranged on the lateral sidewalls of the gate stack 130. Similarly, lateral spacers 140 and 142 are arranged on the sidewalls of the first capacitor-electrode layer 118.

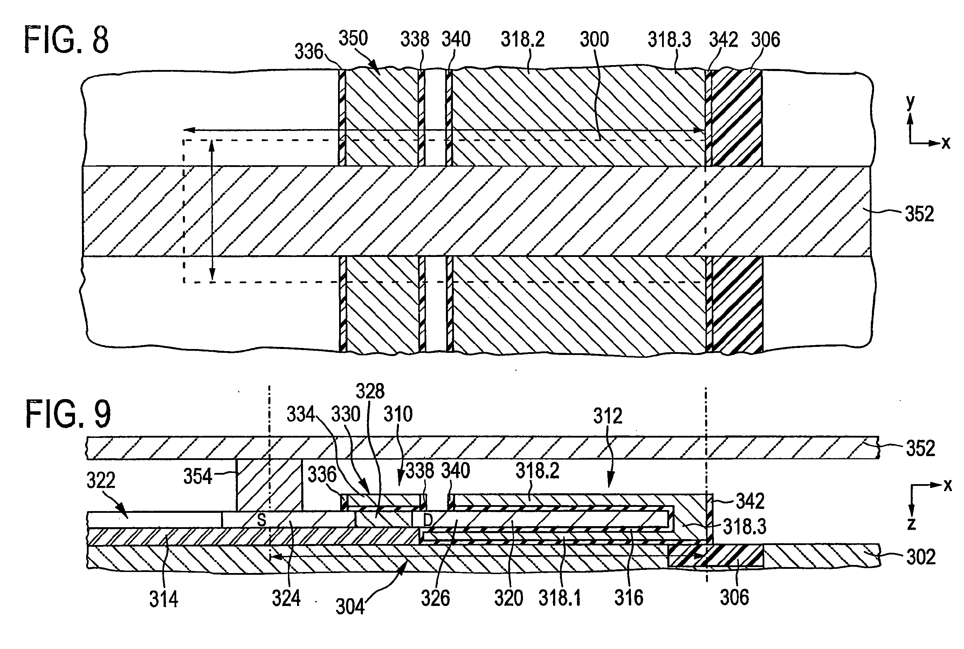

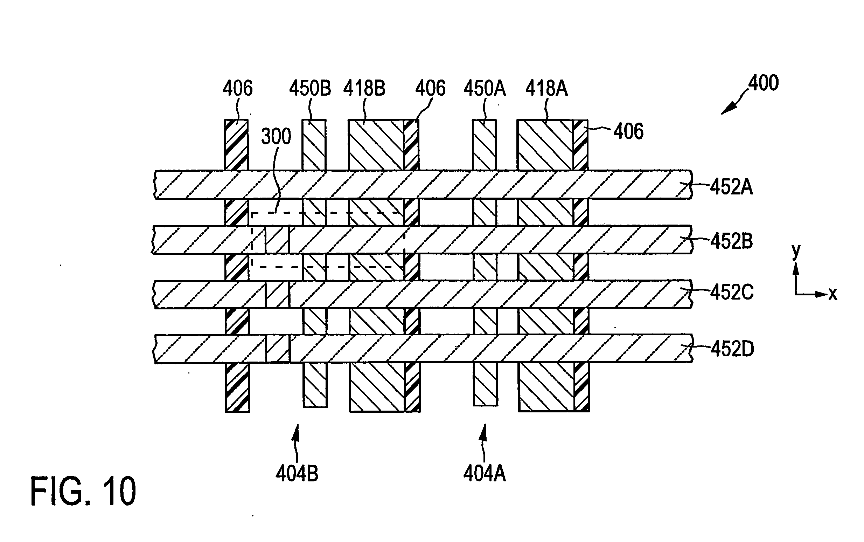

Further structural details for electrically connecting the memory cell 100 to other circuit elements of a memory device are omitted in Fig. 1 for reasons of simplicity of the graphical representation. However, contacting of the memory cell 100 will be addressed in the context of Figs. 9, 10 and of other embodiments.

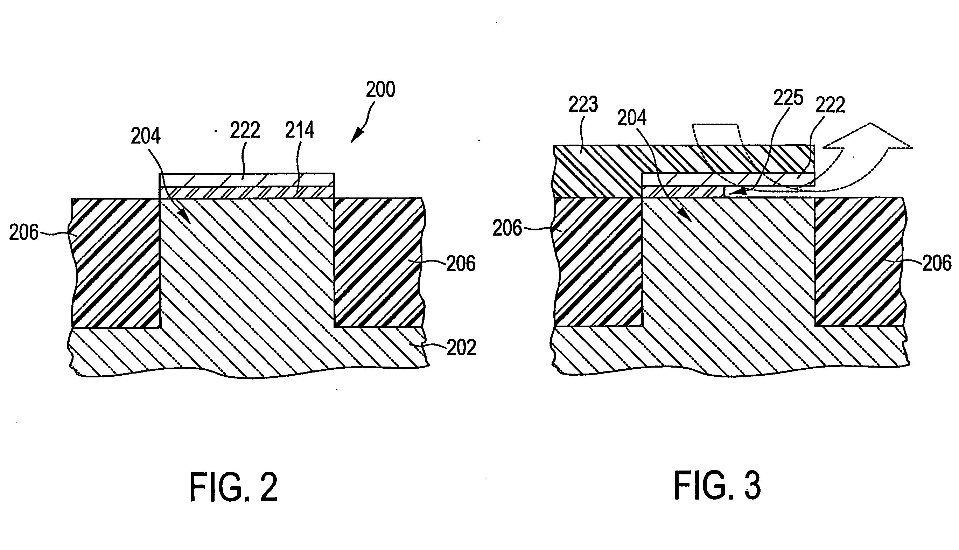

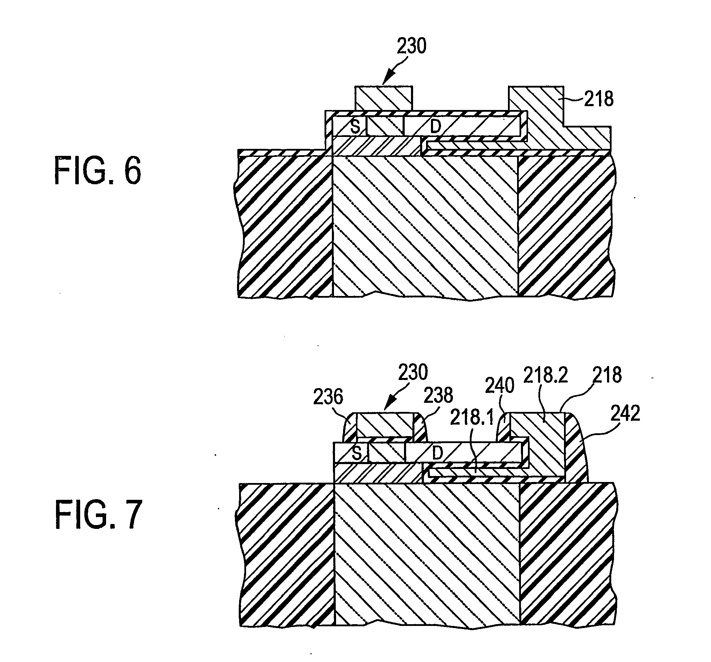

Figs. 2 to 7 show schematic cross-sectional views of a memory cell 200 according to a second embodiment at different stages of its fabrication.. The structure of the memory cell 200 strongly resembles that of the memory cell 100 of Fig. 1. The fabrication method described in the following does not form part of the invention but can therefore also be applied for fabricating the memory cell 100 and for the other memory-cell embodiments presented herein. Minor differences in the structure of the memory cell 200 in comparison with that of Fig. 1 are limited to the memory capacitor and will be discussed later with reference to Fig. 7.

Reference numerals used for the description of Figs. 2 to 7 resemble those of corresponding structural elements of the memory cell 100 of Fig. 1. The only difference lies in the first digit of the reference labels, which is "2" instead of "1", for respective structural elements of the present embodiment corresponding to those of the memory cell 100 of Fig. 1.

The fabrication of memory cell 200 starts with providing a semiconductor substrate 202 with shallow-trench isolation (STI) regions 206 to define active semiconductor regions 204. The semiconductor substrate 202 is a silicon wafer. On the surface of the active semiconductor regions 204 of the silicon wafer 202 a layer stack of a semiconductor intermediate layer 214 and a semiconductor electrode layer 222 is deposited, typically using an epitaxial deposition technique such as metal organic vapor phase epitaxy (MOVPE). The semiconductor intermediate layer is made of SiGe and the semiconductor electrode layer 222 is made of silicon.

Subsequently, a mask 223 is deposited and patterned. The mask covers the layer stacks 214, 222 and at a section of the shallow trench isolation region 206 to the left of the active semiconductor region 206. The STI region, which in Fig. 1 appears to right of the active semiconductor region 204, is not covered by the mask 223. This allows lateral access of an etching agent to the semiconductor intermediate layer 214 in a subsequent processing step. The etching agent used to remove the SiGe of the semiconductor intermediate layer 214 is selected so as to not attack the material of the semiconductor electrode layer 222 and of the active semiconductor region, i.e. it does not attack silicon. A suitable etching agent for this purpose is HCl.

The etching process is continued for a predetermined duration so as to control the lateral extension of a tunnel section 225 that is created between the active semiconductor region 204 and the semiconductor electrode layer 222. The tunnel section 225 extends over approximately half of the lateral extension of the active semiconductor region 204 between the shallow-trench isolation regions on its opposite lateral sides. The result of this processing is shown in Fig. 3. The source and drain region implants are realized after the gate stack patterning and capacitor electrode patterning.

The capacitor electrode can extend in the lateral direction approximately up to a spacer 238 corresponding to the future gate stack. Indeed if the electrode extends under the future gate, a parasitic transistor would appear which could degrade electrical characteristics of architecture.

The doping of the SiGe layer 214 doping is adapted for optimizing the selectivity during the tunnel etching with HCl. The channel doping is adapted to have an adjusted threshold voltage for the selection transistor.

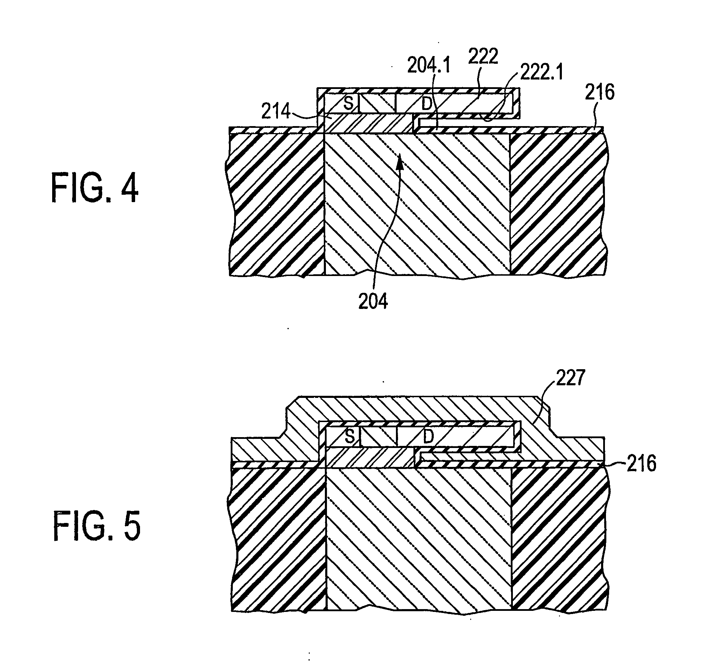

With reference to Fig. 4, after removal of the mask 223, isolation layer 216 is fabricated, which covers all exposed surfaces of the substrate. In particular, the isolation layer 216 also covers the lower phase 222.1 of the semiconductor electrode layer 222 and the exposed surface 204.1 of the active semiconductor region 204, as well as the exposed side faces of the semiconductor intermediate layer 214. The isolation layer 216 can be fabricated as an oxide layer, for instance by thermal oxidation. However, it can also be deposited by other known methods.

Subsequently, as can be seen in Fig. 5, the material of the first electrode layer and of the gate electrode of the control transistor is deposited as a coherent material layer 227. The material can be doped polysilicon or a metal. A metal-layer stack can also be used.

Subsequently, as shown in Fig. 6, a photolithography step and a subsequent gate-stack etching step is applied to pattern the material layer 227 to separate the first capacitor-electrode layer 218 from the gate stack 230. Then, as shown in Fig. 7, lateral spacers 236 to 242 are formed on the gate stack 230 and on the first capacitor electrode layer 218.

As can be seen in the cross-sectional views of Figs. 6 and 7, the first capacitor-electrode layer 218 differs slightly from the first capacitor-electrode layer 118 of the embodiment of Fig. 1. In the present embodiment, the shape of the first capacitor-electrode layer 218 resembles that of the letter J turned on its side, because the first electrode-layer section 218.1 has a longitudinal extension that is more than twice as large as that of the second electrode-layer section 218.2. Note that in the comparison of the shape of the first capacitor-electrode layer 218 no distinction is made between a J-shape and a mirrored J-shape. Fig. 7 shows a mirrored J-shape of the first capacitor-electrode layer 218, but viewing the cross section from the opposite direction would result in a J-shape. Therefore, there is no actual difference between these two shapes.

The process flow stays the same also for the matrix integration scheme according Fig. 10 below, and regardless of the form, be it U- or J-shaped.

Summarizing the processing, a silicium germanium epitaxy is made on a silicon substrate. After this operation, the SiGe layer is selectively removed only one side (that requires the addition of an extra mask) or on both sides according the matrix structure of the memory plan (see matrix integration in Figs. 10 to 12). This step prepares the future implementation of the capacitor. Then a standard CMOS process flow continues with an oxide deposition and a polysilicon deposition (or other gate material). The gate stack of the selection transistor can be realized at the same time of capacitor electrode (118). In that case no specific mask is needed for the capacitor definition. If, however, different dielectric and top electrode materials for the selection-transistor gate stack compared to the capacitor electrode (118) are desired, the process is the following: the electrode of selection transistor is built in first. After an oxide deposition is realized, a metal gate or other gate material is deposited. In this case the photolithography of the capacitor electrode that requires an additional mask. After the capacitor electrode is realized by etching the following stack. The rest of process flow stays the same that the standard CMOS process flow.

Figs. 8 and 9 show schematic top and cross-sectional views, respectively, of a memory cell according to a third embodiment of the invention. The views are aligned laterally so that lateral extensions along a direction x indicated on the right side of both figures are identical in the Figs. However, note that the lateral proportions shown in the Figs. are chosen for purposes of legibility of the Figs. and need not reflect actual lateral proportions used in real devices. The reference labels used in Figs. 8 and 9 for the structural elements of memory cell 300 correspond to those used for the previous embodiments of Fig. 1 and Figs. 2 to 7 in their second and third digits, wherever structural elements of the present embodiment correspond to those of the earlier embodiments. The structure of the memory cell 300 is based on the memory cell 100 of Fig. 1. Note that the lateral extension of the semiconductor active region 304 is shown larger than for the memory cell 100. However, this is only a matter of graphical representation in the figures. The lateral extensions are not drawn to scale and not shown with proportion that correspond to those of a real device.

The memory cell 300 forms an integral part of a memory device, of which only a section is shown in Figs. 8 and 9. The memory cell 300 is indicated by a dashed outline. The gate electrode 334 of the gate stack 330 forms an integral part of a word line 350. The source electrode S of the control transistor 310 is connected to a bit line 352 through a vertical connect element 354. This way, the memory cell can be addressed individually during operation of the memory device.

Fig. 10 shows a memory device 400 with a back-to-front architecture. Two neighboring active semiconductor regions 404a and 404b are shown. The memory device 400 is based on memory cells of the type of memory cell 300 shown in Fig. 8 and 9. It thus forms the matrix arrangement of the elementary structure presented Fig 8 and Fig 9.

A single memory cell is again indicated by shaded hatching and a dashed outline. Each active semiconductor region has one word line extending along the y-direction indicated on the right side of Fig. 10. The bit lines 452A to 452D extend along the x-direction. Memory capacitors are formed in the sections 418a and 418b in each semiconductor active region, respectively.

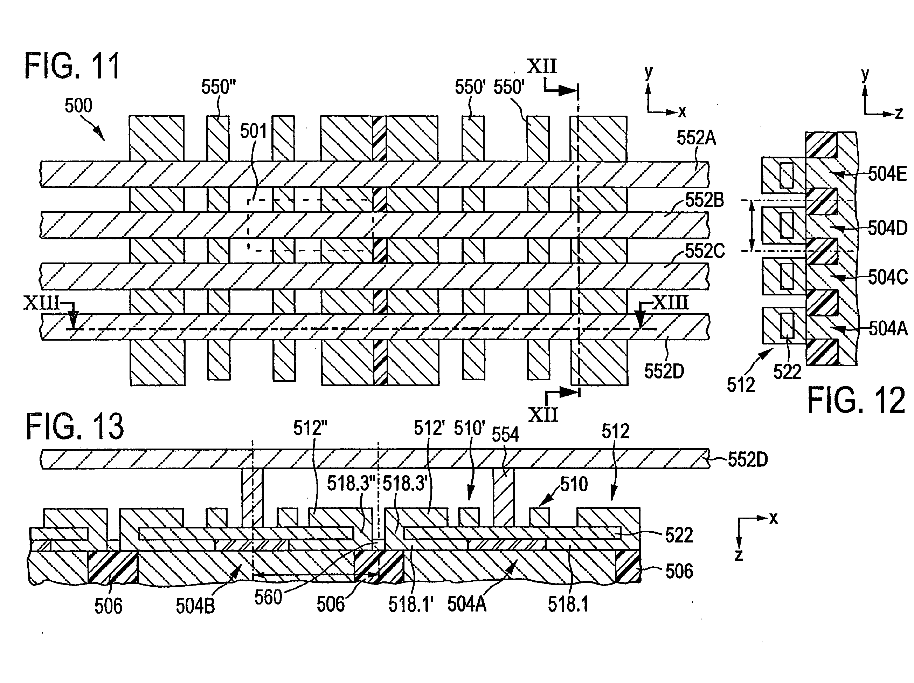

Figs. 11 to 13 show top and sectional views of a memory device with a first back-to-back architecture. Fig. 12 is a cross-sectional view of the memory device 500 of Fig. 11 along the dashed line XII-XII. Fig. 13 is a cross-sectional view of the memory device 500 along the dashed line labeled XIII-XIII in Fig. 11. Note that the three representations of the memory device 500 shown in Figs. 11 to 13 do not correspond to each other in their lateral scaling.

The memory device 500 of Figs. 11 to 13 differs from memory device 400 of Fig. 10 in that the density of memory cells per active semiconductor region is increased. A single memory cell 501 is again indicated by a dashed outline.

Referring to Fig. 13, it is seen that two memory cells are arranged within the lateral extension of the active semiconductor regions 504a and 504b in x-direction. To this end, two control transistors 510 and 510' and two memory capacitors are arranged on opposite lateral sides of a connecting element 554, which couples the memory cells to the corresponding bit line 452D. The memory capacitors 512 and 512' and the control transistors 510 and 510' are arranged according to a mirror symmetry, in the present case in a back-to-back arrangement, on the opposite sides of the connecting element 554. To this end, the semiconductor intermediate layer is processed from both lateral ends during the fabrication to form two tunnel sections for accommodating the respective first electrode-layer sections 518.1 and 518.1' of respective memory cells.

Fig. 12 shows that the lateral extension of the active semiconductor regions in the y-direction corresponds approximately to the extension of the memory capacitor 512.

As can be seen in Fig. 13, adjacent active semiconductor regions 504a and 504b are connected through a semiconductor layer 560, which couples adjacent memory capacitors 512' and 512", which are arranged back-to-back, such that the third electrode-layer sections 518.3' and 518.3" face each other. In this back-to-back arrangement, in the direction parallel to the bit lines 552A to 552D, the respective word lines 550' and 550" are to be considered the front of the respective memory cell.

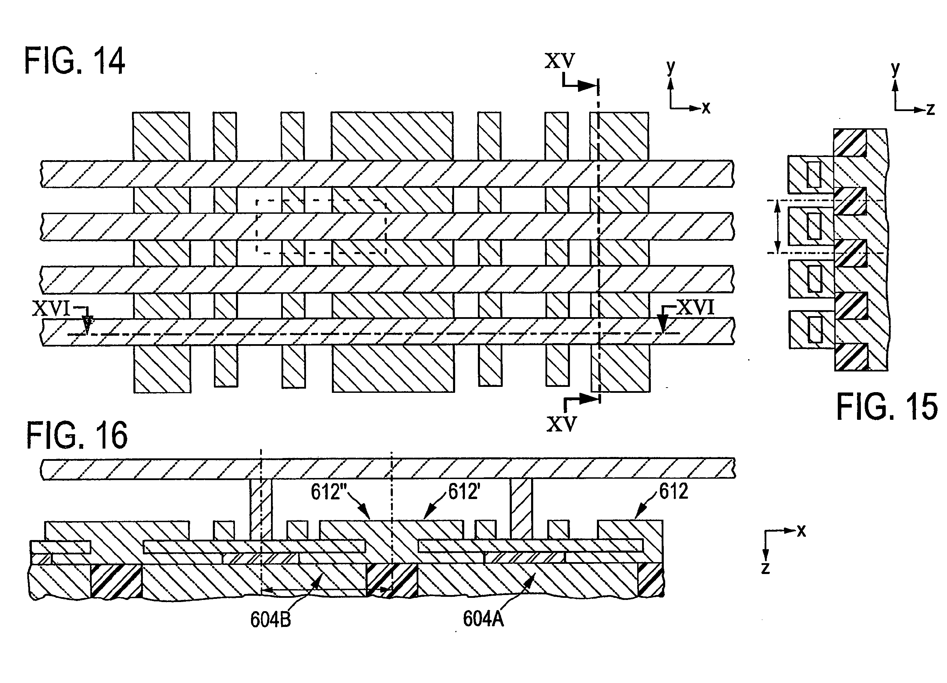

The principle of this embodiment can be further exploited in the embodiment shown in Figs. 14 to 16. Figs. 14 to 16 show top and sectional views of a memory device 600 with a second back-to-back architecture. Fig. 15 is a cross-sectional view of the memory device 600 of Fig. 14 along the dashed line XV-XV. Fig. 16 is a cross-sectional view of the memory device 600 along the dashed line labeled XVI-XVI in Fig. 14. Again, the three representations of the memory device 600 shown in Figs. 14 to 16 do not correspond to each other in their lateral scaling.

The embodiment resembles that of the previous Figs. 11 to 13 with the exception that the capacitor electrodes 612' and 612" in adjacent semiconductor active regions 604a and 604b are directly contacting each other over their whole extension in the z-direction.

This embodiment allows a more integrated architecture. It is not necessary to have a shallow-trench isolation (STI) large enough to have two capacitor electrodes not in short.

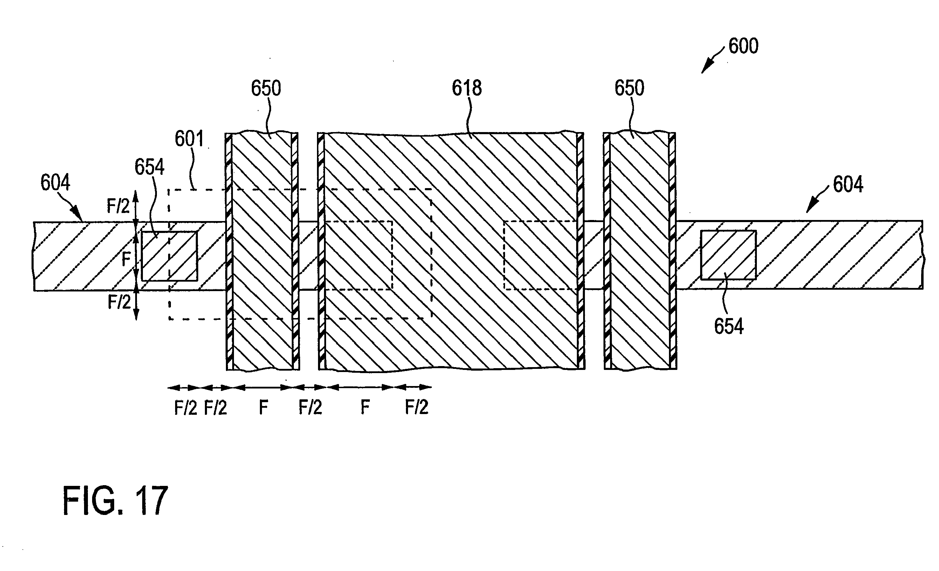

The memory capacitors can be addressed individually by means of the word line.Fig. 17 is a top view of a memory device for illustrating the cell area required by a memory cell. Fig. 17 is a schematic illustration for calculating the area of the memory cell. Assuming a basic minimal lateral extension F, corresponding to a technological node under consideration that can be fabricated by a given technology, the area of a memory cell corresponds to 4F x 2F = 8F². For a F corresponding to 65 nm-CMOS technology node, we obtain a capacitance of 0.5 fF for the memory capacitor. In comparison, standard EDRAM requires a cell area of 25 F². Therefore, if one uses the same area as a standard 65nm EDRAM one obtains a capacitance equal to 3fF For a 65 nm node with a weak junction leakage a capacitance of 3 fF seems suitable.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims.

Note that the terms "horizontal" and "vertical" are only used with an internal reference to the surface of the active semiconductor region, which surface is assumed horizontal in the present context. However, this assumption is made only for the purpose of creating an intuitive mental reference picture, and without intending to restrict the claimed memory-cell structure to a certain orientation with respect to external reference directions, reference planes, or the like.

In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

Any reference signs in the claims should not be construed as limiting the scope.

## Claims

1. A memory cell (100,200,300,501,601), comprising:
- a semiconductor substrate (102) with an active semiconductor region (104), which is laterally defined on a surface region of the semiconductor substrate by isolation regions (106) adjacent to the active semiconductor region,
a control transistor (112) having semiconductor transistor transistor-electrode regions within lateral bounds of the active semiconductor region and the isolation regions, and
a memory capacitor (110) on the active semiconductor region (104), the memory capacitor having a first capacitor-electrode layer, which, in across-sectional view of the memory cell, has first and second electrode-layer sections (118.1, 118.2) that extend on the active semiconductor region in parallel to the surface of the active semiconductor region at a vertical distance to each other and that are electrically connected by a third electrode-layer section (118.3) extending vertically, that is, perpendicular to the surface of the active semiconductor region, wherein:
- the control transistor (112) is connected with a conductive second capacitor electrode layer (120) that extends between the first and second electrode-layer sections and is electrically isolated from them by an isolation layer (116); the memory cell being **characterized by**
- a semiconductor intermediate layer (114) is arranged on the surface region in the active semiconductor region,
- a semiconductor electrode layer (122) is arranged on the intermediate layer and comprises at least one of the transistor-electrode regions (124,126) and
- the semiconductor electrode layer continues laterally into the second capacitor electrode layer (120).

2. The memory cell of claim 1 wherein
the first electrode layer (118, 218) has a shape that in the cross-sectional view resembles either the letter J turned on its side or the letter U turned on its side.

3. The memory cell of claim 1 or claim 2, wherein the intermediate laver (114) is made of a semiconductor material, which is selectively removable with respect to the semiconductor substrate and to the second capacitor electrode layer.

4. The memory cell of any preceding claim, wherein the control transistor (112) is a MOSFET having source and dram regions (124,126) arranged as transistor-electrode regions in the electrode layer, and wherein the drain region, (126) continues laterally into the second capachor-electrode layer (120).

5. The memory cell of claim 4, wherein the MOSFET has a gate-electrode layer (134), which is made of an identical electrically conductive material as, the first capacitor-electrode layer (118).

6. The memory cell of claim 4, wherein the MOSPHT has a gate-electrode layer (134), which is made of an electrically conductive in material different from that of the first capacitor-electrode layer (118).

7. A memory device (400. 500, 600) comprising a plurality of memory cells (300,501, 601) according to any preceding claim.

8. The memory device of claim 7, wherein the memory cells are in a matrix, arrangement, each memory cell being connected to a respective unique combination of word and bit lines (350,352; 450,452; 550, 552) via two of its transistor-electrode regions.

9. The memory device (400) of claim 7, wherein adjacent memory cells (300, 404A,404B) of the matrix arrangement are in a back-to-front arrangement in a direction parallel to the bit lines (452A to D), wherein the third electrode-layer section (318.3) is to be considered the back side and the word line (350) is to be considered the front side of a memory cell.

10. The memory device (500) of claim 7, wherein adjacent memory cells (501, 512', 512") of the matrix arrangement are in a back-to-back arrangement in a direction parallel to the bit lines, wherein the third electrode-layer section (5183', 518.3:") is to be considered the back side and the word line(550% 550") is to be considered the front of a memory cell.

## Patentansprüche

1. Speicherzelle (100, 200, 300, 501, 601), aufweisend:
- ein Halbleitersubstrat (102) mit einem aktiven Halbleiterbereich (104), der seitlich auf einem Oberflächenbereich des Halbleitersubstrats durch Isolationsbereiche (106), die benachbart zu dem aktiven Halbleiterbereich sind, definiert ist,
- einen Steuertransistor (112), der Halbleitertransistorelektrodenbereiche innerhalb seitlicher Grenzen des aktiven Halbleiterbereichs und der Isolationsbereiche aufweist, und
- einen Speicherkondensator (110) auf dem aktiven Halbleiterbereich (104), wobei der Speicherkondensator eine erste Kondensatorelektrodenschicht aufweist, die, in einer Querschnittsansicht der Speicherzelle, erste und zweite Elektrodenschichtabschnitte (118.1, 118.2) aufweist, die sich auf dem aktiven Halbleiterbereich parallel zu der Oberfläche des aktiven Halbleiterbereichs in einer vertikalen Distanz zueinander erstrecken und die elektrisch durch einen dritten Elektrodenschichtabschnitt (118.3) verbunden sind, der sich vertikal, das heißt senkrecht zu der Oberfläche des aktiven Halbleiterbereichs, erstreckt, wobei:
- der Steuertransistor (112) mit einer leitenden zweiten Kondensatorelektrodenschicht (120) verbunden ist, die sich zwischen den ersten und zweiten Elektrodenschichtabschnitten erstreckt und die elektrisch von diesen durch eine Isolationsschicht (116) isoliert ist;
wobei die Speicherzelle **gekennzeichnet ist durch**
- eine Halbleiterzwischenschicht (114) ist auf dem Oberflächenbereich in dem aktiven Halbleiterbereich angeordnet,
- eine Halbleiterelektrodenschicht (122) ist auf der Zwischenschicht angeordnet und weist zumindest einen der Transistorelektrodenbereiche (124, 126) auf, und
- die Halbleiterelektrodenschicht setzt sich seitlich in die zweite Kondensatorelektrodenschicht (120) fort.

2. Speicherzelle gemäß Anspruch 1, wobei
die erste Elektrodenschicht (118, 218) eine Form aufweist, die in der Querschnittsansicht entweder dem Buchstaben J auf seine Seite gedreht oder dem Buchstaben U auf seine Seite gedreht ähnelt.

3. Speicherzelle gemäß Anspruch 1 oder Anspruch 2, wobei die Zwischenschicht (114) aus einem Halbleitermaterial hergestellt ist, das selektiv in Bezug auf das Halbleitersubstrat und auf die zweite Kondensatorelektrodenschicht entfernbar ist,

4. Speicherzelle gemäß einem der vorhergehenden Ansprüche, wobei der Steuertransistor (112) ein MOSFET ist, der Source- und Drainbereiche (124, 126) aufweist, die als Transistorelektrodenbereiche in der Elektrodenschicht angeordnet sind, und wobei der Drainbereich (126) sich seitlich in die zweite Kondensatorelektrodenschicht (120) fortsetzt.

5. Speicherzelle gemäß Anspruch 4, wobei der MOSFET eine Gateelektrodenschicht (134) aufweist, die aus einem identischen elektrisch leitenden Material hergestellt ist wie die erste Kondensatorelektrodenschicht (118).

6. Speicherzelle gemäß Anspruch 4, wobei der MOSFET eine Gateelektrodenschicht (134) aufweist, die aus einem elektrisch leitenden Material anders als das der ersten Kondensatorelektrodenschicht (118) hergestellt ist.

7. Speichervorrichtung (400, 500, 600) aufweisend eine Mehrzahl von Speicherzellen (300, 501, 601) gemäß einem der vorhergehenden Ansprüche.

8. Speichervorrichtung gemäß Anspruch 7, wobei die Speicherzellen in einer Matrixanordnung sind, wobei jede Speicherzelle mit einer jeweiligen einmaligen Kombination von Wort- und Bitleitungen (350, 352; 450, 452; 550, 552) über zwei von ihren Transistorelektrodenbereichen verbunden ist.

9. Speichervorrichtung (400) gemäß Anspruch 7, wobei benachbarte Speicherzellen (300, 404A, 404B) der Matrixanordnung in einer Vorder-an-Rück-Anordnung in einer Richtung parallel zu den Bitleitungen (452A bis D) sind, wobei der dritte Elektrodenschichtabschnitt (318.3) als die Rückseite gilt und die Wortleitung (350) als die Vorderseite einer Speicherzelle gilt.

10. Speichervorrichtung (500) gemäß Anspruch 7, wobei benachbarte Speicherzellen (501, 512', 512") der Matrixanordnung in einer Rück-an-Rück-Anordnung in einer Richtung parallel zu den Bitleitungen sind, wobei der dritte Elektrodenschichtabschnitt (518.3', 518.3") als die Rückseite gilt und die Wortleitung (550', 550") als die Vorderseite einer Speicherzelle gilt.

## Revendications

1. Cellule de mémoire (100, 200, 300, 501, 601), comprenant :
- un substrat de semi-conducteurs (102) avec une région active de semi-conducteurs (104) qui est définie latéralement sur une région de surface du substrat de semi-conducteurs par des régions d'isolation (106) adjacentes à la région active de semi-conducteurs,
- un transistor de commande (112) ayant des régions d'électrodes de transistor à semi-conducteurs dans les limites latérales de la région active de semi-conducteurs et des régions d'isolation, et
- un condensateur de mémoire (110) sur la région active de semi-conducteurs (104), le condensateur de mémoire ayant une première couche d'électrode de condensateur qui, dans une vue en coupe de la cellule de mémoire, a une première et une deuxième sections de couche d'électrodes (118.1, 118.2) qui se prolongent sur la région active de semi-conducteurs parallèlement à la surface de la région active de semi-conducteurs, à une distance verticale l'une de l'autre, et qui sont raccordées électriquement par une troisième section de couche d'électrodes (118.3) s'étendant verticalement, c'est-à-dire perpendiculairement à la surface de la région active de semi-conducteurs, dans laquelle :
- le transistor de commande (112) est raccordé avec une deuxième couche d'électrodes de condensateur conductrice (120) qui s'étend entre la première et la deuxième sections de couche d'électrodes et qui est isolée de celles-ci par une couche d'isolation (116) ;
la cellule de mémoire étant **caractérisée par le fait que** :
- une couche intermédiaire de semi-conducteurs (114) est disposée sur la région de surface dans la région active de semi-conducteurs,
- une couche d'électrodes de semi-conducteurs (122) est disposée sur la couche intermédiaire et elle comporte au moins une des régions d'électrodes de transistor (124, 126), et
- la couche d'électrodes de semi-conducteurs se prolonge latéralement dans la deuxième couche d'électrodes de condensateur (120).

2. Cellule mémoire selon la revendication 1, dans laquelle la première couche d'électrode (118, 218) a une forme qui ressemble en coupe soit à la lettre J tournée sur le côté soit à la lettre U tournée sur le côté.

3. Cellule de mémoire selon la revendication 1 ou la revendication 2, dans laquelle la couche intermédiaire (114) est réalisée dans un matériau semi-conducteur qui peut être éliminé de manière sélective par rapport au substrat semi-conducteur et à la deuxième couche d'électrode de condensateur.

4. Cellule de mémoire selon l'une quelconque des revendications précédentes, dans laquelle le transistor de commande (112) est un MOSFET ayant des régions de source et de drain (124, 126) disposées comme des régions d'électrodes de transistor dans la couche d'électrodes, et dans laquelle la région de drain (126) se prolonge latéralement dans la deuxième couche d'électrode de condensateur (120).

5. Cellule de mémoire selon la revendication 4, dans laquelle le MOSFET a une couche d'électrode de grille (134) qui est faite d'un matériau électriquement conducteur identique à celui de la première couche d'électrode de condensateur (118).

6. Cellule de mémoire selon la revendication 4, dans laquelle le MOSFET a une couche d'électrode de grille (134) qui est faite d'un matériau électriquement conducteur différent de celui de la première couche d'électrode de condensateur (118).

7. Dispositif de mémoire (400, 500, 600) comportant un pluralité de cellules de mémoire (300, 501, 601) selon l'une quelconque des revendications précédentes.

8. Dispositif de mémoire selon la revendication 7, dans lequel les cellules de mémoire sont dans une disposition matricielle, chaque cellule de mémoire étant raccordée à une combinaison respective unique de lignes de mot et de lignes de bit (350, 352 ; 450, 452 ; 550, 552) par l'intermédiaire de deux de ses régions d'électrodes de transistor.

9. Dispositif de mémoire (400) selon la revendication 7, dans lequel des cellules de mémoire (300, 404A, 404B) adjacentes dans la disposition matricielle sont dans une disposition avant-arrière dans une direction parallèle aux lignes de bit (452 A à D), dans lequel la troisième section de couche d'électrode (318.3) doit être considérée comme le côté arrière et la ligne de mot (350) doit être considérée comme le côté avant d'une cellule de mémoire.

10. Dispositif de mémoire (500) selon la revendication 7, dans laquelle des cellules de mémoire (501, 512', 512") adjacentes dans la disposition matricielle sont dans une disposition avant-arrière dans une direction parallèle aux lignes de bit, dans lequel la troisième section de couche d'électrode (518.3', 518.3") doit être considérée comme le côté arrière et la ligne de mot (550', 550") doit être considérée comme le côté avant d'une cellule de mémoire.
